(19) Europäisches Patentamt
European Patent Office
Office européen des brevets

(11) **EP 2 951 598 B1**

(12) **EUROPÄISCHE PATENTSCHRIFT**

(45) Veröffentlichungstag und Bekanntmachung des Hinweises auf die Patenterteilung:
**11.09.2019 Patentblatt 2019/37**

(21) Anmeldenummer: **13715647.7**

(22) Anmeldetag: **28.03.2013**

(51) Int Cl.:
*G01R 27/16* (2006.01)   *F03D 7/02* (2006.01)
*H02J 3/38* (2006.01)

(86) Internationale Anmeldenummer:
**PCT/EP2013/056768**

(87) Internationale Veröffentlichungsnummer:
**WO 2014/154298 (02.10.2014 Gazette 2014/40)**

(54) **VERFAHREN ZUR RECHNERGESTÜTZTEN ERMITTLUNG DER IMPEDANZ EINES ELEKTRISCHEN ENERGIENETZES**

METHOD FOR COMPUTER-AIDED ASCERTAINMENT OF THE IMPEDANCE OF AN ELECTRICAL ENERGY NETWORK

PROCÉDÉ ASSISTÉ PAR ORDINATEUR SERVANT À DÉTERMINER L'IMPÉDANCE D'UN RÉSEAU D'ÉNERGIE ÉLECTRIQUE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(43) Veröffentlichungstag der Anmeldung:
**09.12.2015 Patentblatt 2015/50**

(73) Patentinhaber: **Siemens Aktiengesellschaft 80333 München (DE)**

(72) Erfinder:
- **ANDRESEN, Björn**
  **DK-8752 Ostbirk (DK)**
- **GOLDENBAUM, Nikolaus**
  **8600 Silkeborg (DK)**
- **OBRADOVIC, Dragan**
  **85521 Ottobrunn (DE)**
- **SZABO, Andrei**
  **85521 Ottobrunn (DE)**

(56) Entgegenhaltungen:
**EP-A1- 2 397 689     WO-A1-2012/166933
DE-C1- 19 522 496**

- **HANDSCHIN ET AL: "Inselnetzerkennung bei Eigenenergieerzeugungsanlagen", ELEKTROTECHNISCHE ZEITSCHRIFT - ETZ, VDE VERLAG GMBH, BERLIN, DE, Bd. 125, 1. Januar 2004 (2004-01-01), Seiten 48-50, XP009173595, ISSN: 0948-7387**

EP 2 951 598 B1

**Beschreibung**

Die Erfindung betrifft ein Verfahren zur rechnergestützten Ermittlung der Impedanz eines elektrischen Energienetzes sowie eine elektrische Energieerzeugungsanlage und ein Computerprogrammprodukt.

Zur geeigneten Steuerung einer Energieerzeugungsanlage, welche an einem Anschlusspunkt mit einem Energienetz verbunden ist, wird in der Regel die Impedanz des Energienetzes als Parameter benötigt. Zur Schätzung dieser Impedanz sind aus dem Stand der Technik verschiedene Verfahren bekannt. In einer Methodik werden die elektrischen Komponenten des Energienetzes rechnergestützt modelliert und mit dieser Modellierung Eigenschaften des Netzes und insbesondere seine Impedanz am Anschlusspunkt berechnet. Solche Verfahren sind jedoch komplex und erfordern bei Modifikationen des Energienetzes eine kontinuierliche Aktualisierung. Ferner ist es bekannt, Eigenschaften des Energienetzes durch eine aktive Veränderung von Parametern der Energieerzeugungsanlage zu bestimmen, was jedoch den Nachteil aufweist, dass der Normalbetrieb der Anlage gestört wird.

Das Dokument Handschin et al. "Inselnetzerkennung bei Eigenerzeugungsanlagen", ELEKTROTECHNISCHE ZEITSCHRIFT - ETZ, VDE VERLAG GMBH, BERLIN, DE, Bd. 125, 1. Januar 2004, Seiten 48 bis 50, offenbart die Verwendung einer Impedanzmessung zur Inselnetzerkennung von Energieerzeugungsanlagen. Dabei wird ein Strom in das Netz eingespeist und die Reaktion des Netzes am Anschlusspunkt gemessen.

Die Druckschrift DE 195 22 496 C1 beschreibt ein Verfahren zur Messung der Netzimpedanz bei netzgekoppelten Wechselrichtern bzw. Umrichtern durch kurzzeitige Spannungsüberhöhung am Einspeisepunkt.

Das Dokument EP 2 397 689 A1 offenbart ein Verfahren zur Steuerung einer Energieerzeugungsanlage. Dabei werden u.a. die Netzspannung und der Netzstrom am Netzkopplungspunkt der Energieerzeugungsanlage gemessen.

In der Druckschrift WO 2012/166933 A1 ist ein Verfahren zur Detektion der Netzimpedanz anhand eines überlagerten Hochfrequenzsignals beschrieben.

Aufgabe der Erfindung ist es deshalb, die Impedanz eines elektrischen Energienetzes in einfacher Weise mit einem rechnergestützten Verfahren zu bestimmen.

Diese Aufgabe wird durch die unabhängigen Patentansprüche gelöst. Weiterbildungen der Erfindung sind in den abhängigen Ansprüchen definiert.

Das erfindungsgemäße Verfahren dient zur rechnergestützten Ermittlung der Impedanz eines elektrischen Energienetzes bzw. Stromnetzes, wobei an einem Anschlusspunkt, an dem eine Energieerzeugungsanlage an das Energienetz angeschlossen ist, zu jeweiligen aufeinander folgenden Zeitpunkten die elektrische Spannung, die Wirkleistung und die Blindleistung gemessen werden. Hier und im Folgenden ist unter einer gemessenen Spannung immer ein reeller Spannungswert (Spannungsamplitude) zu verstehen, d.h. die Phase der gemessenen Spannung wird nicht bestimmt. Im erfindungsgemäßen Verfahren wird ein Impedanzwert des Energienetzes basierend auf den nachfolgend beschriebenen Schritten a) bis d) ermittelt. In diesen Schritten werden entsprechende Bedingungen durch die Formulierung "nur im Falle, dass" spezifiziert. Hierunter ist zu verstehen, dass nur im Falle, dass die Bedingung vorliegt, der entsprechende Schritt durchgeführt wird und ansonsten die Ermittlung des Impedanzwerts zum entsprechenden (aktuellen) Zeitpunkt abgebrochen wird.

Im ersten Schritt a) des Verfahrens wird zu einem jeweiligen aktuellen Zeitpunkt ermittelt, ob die betragsmäßige Veränderung der gemessenen Spannung zwischen dem vorhergehenden und dem aktuellen Zeitpunkt und die betragsmäßige Veränderung der gemessenen Blindleistung zwischen dem vorhergehenden und dem aktuellen Zeitpunkt ein erstes Kriterium erfüllen. Das erste Kriterium ist dann erfüllt, wenn die betragsmäßige Veränderung der gemessenen Spannung größer als ein erster Schwellwert ist und die betragsmäßige Veränderung der gemessenen Blindleistung größer als zweiter Schwellwert ist.

In einem Schritt b) wird nur im Falle, dass die betragsmäßigen Veränderungen der gemessenen Spannung und der gemessenen Blindleistung das erste Kriterium erfüllen, ermittelt, ob die Veränderungen der gemessenen Spannung und der gemessenen Blindleistung ein zweites Kriterium erfüllen, wobei das zweite Kriterium dann erfüllt ist, wenn die Veränderungen der gemessenen Spannung und der gemessenen Blindleistung durch die Energieerzeugungsanlage verursacht sind, wobei das zweite Kriterium derart überprüft wird, dass das Vorzeichen der Veränderung der gemessenen Spannung mit dem Vorzeichen der Veränderung der gemessenen Blindleistung verglichen wird, wobei das zweite Kriterium dann erfüllt ist, wenn die beiden Vorzeichen übereinstimmen. Hier und im Folgenden ist unter dem Begriff Veränderung ohne Zusatz "betragsmäßig" eine vorzeichenbehaftete, nicht-betragsmäßige Veränderung zu verstehen.

In einem Schritt c) wird nur im Falle, dass die Veränderungen der gemessenen Spannung und der gemessenen Blindleistung das zweite Kriterium erfüllen, ein Impedanzwert basierend auf einer Rechenvorschrift geschätzt, welche unabhängig von der Phase der gemessenen Spannung ist, und auf der Annahme einer konstanten Phase der gemessenen Spannung beruht. Dabei wird auch ein Schätzfehler für den geschätzten Impedanzwert bebestimmt, wobei ferner die Veränderung der Wirkleistung zwischen dem vorhergehenden und dem aktuellen Zeitpunkt ermittelt wird, wobei der Schätzfehler basierend auf einer vorbestimmten Relation bestimmt wird, welche den Schätzfehler in Abhängigkeit von der gemessenen Wirkleistung, der betragsmäßigen Veränderung der gemessenen Wirkleistung und der betragsmäßigen Veränderung der gemessenen Blindleistung angibt.

In einem Schritt d) stellt nur im Falle, dass der Schätzfehler kleiner als eine vorbestimmte Fehlerschwelle ist, der geschätzte Impedanzwert den ermittelten Impedanzwert dar, d.h. nur in diesem Fall wird der Impedanzwert durch den geschätzten Impedanzwert aktualisiert.

Dem erfindungsgemäßen Verfahren liegt die Erkenntnis zugrunde, dass in einem induktiven Energienetz (d.h. einem Energienetz mit kleinem oder keinem Realteil der Impedanz), an das üblicherweise Energieerzeugungsanlagen angeschlossen werden, Betriebspunkte auftreten, bei denen mit einer einfachen Rechenvorschrift ohne Berücksichtigung der Phase der gemessenen Spannungen die Impedanz genau bestimmt werden kann. Die Erfinder haben dabei erkannt, dass die Rechenvorschrift nur dann mit ausreichender Genauigkeit verwendet werden kann, wenn eine größere Variation der am Anschlusspunkt gemessenen Spannung und Blindleistung auftritt und gleichzeitig die Variation der Wirkleistung gering ist, wobei letztere Bedingung über den Schätzfehler indirekt überprüft wird.

In einer weiteren Variante des erfindungsgemäßen Verfahrens ist die vorbestimmte Fehlerschwelle aus Schritt d) der Schätzfehler, der in dem zuletzt vor dem aktuellen Zeitpunkt durchgeführten Schritt d) ermittelt wurde. Auf diese Weise wird sichergestellt, dass der Impedanzwert immer nur dann aktualisiert wird, wenn sein Schätzfehler kleiner wird.

Vorzugsweise werden der oben definierte erste und zweite Schwellwert unter Berücksichtigung einer (vorab ermittelten) prozentualen Messgenauigkeit festgelegt, so dass sichergestellt ist, dass die Veränderungen nicht durch Messfehler verursacht sind. Dabei ist der erste Schwellwert ein Produkt aus einem positiven Faktor größer Eins und einer prozentualen Messgenauigkeit der gemessenen Spannung und/oder der zweite Schwellwert ist das Produkt aus einem positiven Faktor größer Eins und einer prozentualen Messgenauigkeit der gemessenen Leistung. Als positiver Faktor hat sich insbesondere der Wert 5 als praktikabel erwiesen.

In einer weiteren Variante wird ferner die Veränderung der Wirkleistung zwischen dem vorhergehenden und dem aktuellen Zeitpunkt ermittelt, wobei die Ermittlung des Impedanzwerts zum aktuellen Zeitpunkt abgebrochen wird, wenn die betragsmäßige Veränderung der Wirkleistung größer als ein dritter Schwellwert ist. Hierdurch wird die erfindungsgemäße Erkenntnis berücksichtigt, dass eine genaue Schätzung der Impedanz nur bei geringer Variation der Wirkleistung möglich ist.

In einer weiteren Ausgestaltung des erfindungsgemäßen Verfahrens, kann die Ermittlung der Relation dabei für ein beispielhaftes Energienetz durch Vergleich von mit der obigen Rechenvorschrift geschätzten Impedanzwerten mit den tatsächlich auftretenden Impedanzwerten erzeugt werden. Zur Bestimmung des tatsächlichen Impedanzwerts kann das Energienetz mit an sich bekannten Verfahren simuliert werden bzw. ein reales Energienetz sein. Die Relation kann z.B. in der Form von einer oder mehrerer Tabellen hinterlegt sein. In der detaillierten Beschreibung findet sich beispielhaft eine graphische Darstellung einer Relation.

In einer weiteren Variante des erfindungsgemäßen Verfahrens wird der Impedanzwert in Schritt c) über die gemessenen Spannungen, die gemessenen Wirkleistungen und die gemessenen Blindleistungen zu einer Anzahl von Zeitpunkten umfassend den aktuellen und einen oder mehrere vorhergehende Zeitpunkte basierend auf einer oder mehreren der folgenden Gleichungen geschätzt, wobei diese Gleichungen eine Variante der Rechenvorschrift aus Schritt c) darstellen:

$$Z_{GE} = \frac{U_2 - U_1}{\left(\dfrac{P_2}{U_2} - \dfrac{P_1}{U_1}\right) - \left(\dfrac{jQ_2}{U_2} - \dfrac{jQ_1}{U_1}\right)}$$

wobei $Z_{GE}$ der geschätzte Impedanzwert ist;
wobei $U_2$ die gemessene Spannung, $Q_2$ die gemessene Blindleistung und $P_2$ die gemessene Wirkleistung am Anschlusspunkt zu einem Zeitpunkt aus der Anzahl von Zeitpunkten ist;
wobei $U_1$ bzw. $Q_1$ bzw. $P_1$ die gemessene Spannung bzw. die gemessene Blindleistung bzw. die gemessene Wirkleistung am Anschlusspunkt zu dem Zeitpunkt vor dem Zeitpunkt ist, an dem die Spannung $U_2$, die Blindleistung $Q_2$ und die Wirkleistung $P_2$ gemessen werden.

Das obige Gleichungssystem kann in an sich bekannter Weise basierend auf der Minimierung des mittleren quadratischen Fehlers gelöst werden. In einer einfachen Variante umfasst das Gleichungssystem nur eine Gleichung, sofern nur Werte zum aktuellen und zum vorhergehenden Zeitpunkt berücksichtigt werden.

In einer weiteren Variante werden im Falle, dass die Zeitspanne seit dem letzten Zeitpunkt, an dem Schritt d) durchgeführt wurde, eine vorbestimmte Schwelle überschreitet, ein oder mehrere Parameter der Energieerzeugungsanlage derart variiert, dass die Spannung und/oder die Blindleistung am Anschlusspunkt verändert werden. Die Variation der Parameter löst dabei die Durchführung der obigen Schritte a) bis d) des erfindungsgemäßen Verfahrens aus. Auf diese Weise wird erreicht, dass durch eine aktive Anregung der Energieerzeugungsanlage Betriebsparameter verändert werden, was zu einer Neuschätzung des Impedanzwerts führen kann. Vorzugsweise ist die Variation der Parameter der Energieerzeugungsanlage dabei derart ausgestaltet, dass die Wirkleistung am Anschlusspunkt konstant bleibt. Auf diese Weise wird berücksichtigt, dass bei im Wesentlichen konstanter Wirkleistung der oben beschriebene Schätzfehler klein wird, was zu einer Neubestimmung des Impedanzwerts führt.

In einer weiteren Ausgestaltung werden im Falle, dass die betragsmäßige Veränderung der gemessenen Spannung größer als ein vierter Schwellwert ist, der größer als der erste Schwellwert ist, und/oder die betragsmäßige Veränderung der gemessenen Blindleistung größer als ein fünfter Schwellwert ist, der größer als der zweite Schwellwert ist, und die betragsmäßigen Veränderungen der gemessenen Spannung und der gemessenen Blindleistung das zweite Kriterium nicht erfüllen, ein oder mehrere Parameter der Energieerzeugungsanlage derart variiert, dass die Spannung und/oder die Blindleistung am Anschlusspunkt verändert werden. Die Variation der Parameter löst dabei die Durchführung der obigen Schritte a) bis d) des erfindungsgemäßen Verfahrens aus. Hierdurch wird der Tatsache Rechnung getragen, dass bei größeren Ereignissen im Energienetz die Impedanz des Netzes verändert wird, so dass eine Neuberechnung der Impedanz ausgelöst werden sollte. Die Variation der Parameter der Energieerzeugungsanlage ist dabei vorzugsweise derart ausgestaltet, dass die Wirkleistung am Anschlusspunkt konstant bleibt, so dass die Variation auch tatsächlich zu einer Neubestimmung der Impedanz führt.

In einer bevorzugten Variante wird das erfindungsgemäße Verfahren in einem Energienetz eingesetzt, an dem eine Energieerzeugungsanlage in der Form einer Windturbine oder eines Windparks aus mehreren Windturbinen angeschlossen ist. Nichtsdestotrotz kann das Verfahren ggf. auch für andere Energieerzeugungsanlagen verwendet werden.

Neben dem oben beschriebenen Verfahren betrifft die Erfindung ferner eine elektrische Energieerzeugungsanlage, wobei die Energieerzeugungsanlage derart ausgestaltet ist, dass sie bei Anschluss an einem Anschlusspunkt eines Energienetzes das erfindungsgemäße Verfahren bzw. eine oder mehrere bevorzugte Varianten des erfindungsgemäßen Verfahrens durchführt. Die ermittelten Impedanzwerte können dann direkt von entsprechenden Steuereinheiten der Energieerzeugungsanlage verarbeitet werden, um den Betrieb der Energieerzeugungsanlage geeignet an das Energienetz anzupassen.

Die Erfindung betrifft darüber hinaus ein Computerprogrammprodukt mit einem auf einem maschinenlesbaren Träger gespeicherten Programmcode zur Durchführung des erfindungsgemäßen Verfahrens bzw. einer oder mehrerer bevorzugter Varianten des erfindungsgemäßen Verfahrens, wenn der Programmcode auf einem Computer ausgeführt wird.

Ausführungsbeispiele der Erfindung werden nachfolgend anhand der beigefügten Figuren detailliert beschrieben.

Es zeigen:

Fig. 1　eine schematische Darstellung eines dreiphasigen Energienetzes mit einem Anschlusspunkt für eine Energieerzeugungsanlage, in dem eine Ausführungsform des erfindungsgemäßen Verfahrens durchgeführt wird;

Fig. 2　die Modellierung der Impedanz des dreiphasigen Energienetzes der Fig. 1 durch ein einphasiges Phasensystem;

Fig. 3　eine schematische Darstellung, welche die wesentlichen Schritte einer Ausführungsform des erfindungsgemäßen Verfahrens verdeutlicht; und

Fig. 4　ein Beispiel einer graphischen Darstellung einer Relation zur Bestimmung eines Schätzfehlers für die erfindungsgemäß geschätzte Impedanz.

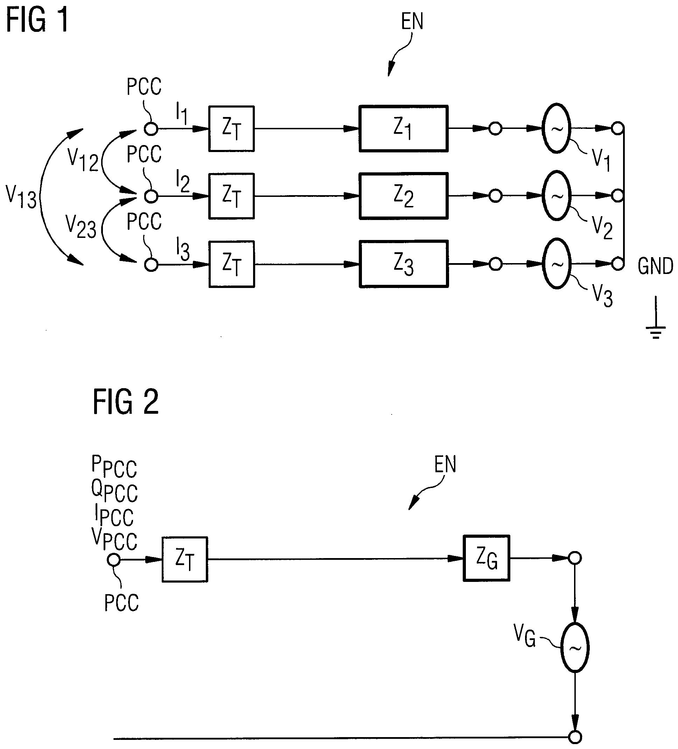

Die nachfolgende Ausführungsform des erfindungsgemäßen Verfahrens wird basierend auf einem dreiphasigen Energienetz beschrieben, welches als Thevenin-Äquivalent in Fig. 1 gezeigt ist. Die Impedanz in den einzelnen Phasen 1, 2 und 3 des Energienetzes ist mit $Z_1$ $Z_2$ und $Z_3$ bezeichnet. Die entsprechenden Spannungen im Stromnetz sind mit $V_1$, $V_2$ und $V_3$ bezeichnet. An das Energienetz wird eine Energieerzeugungsanlage (nicht gezeigt) über den Punkt PCC (PCC = Point of Common Coupling) angeschlossen, wobei der Anschlusspunkt nochmals separat für die drei Phasen wiedergegeben ist. Der in den Phasen vorhandene Storm ist mit $I_1$, $I_2$ und $I_3$ bezeichnet. Ferner ist ein Transformator für die einzelnen Phasen vorhanden, dessen Impedanz mit $Z_T$ bezeichnet ist. Diese Impedanz wird im Folgenden in die jeweiligen Impedanzen $Z_1$, $Z_2$ und $Z_3$ hineingerechnet. Die Spannungen zwischen den einzelnen Phasen sind in Fig. 1 mit $V_{12}$, $V_{13}$ und $V_{23}$ bezeichnet.

Im Rahmen der hier beschriebenen Ausführungsform wird von einem balancierten drei-phasigen Energienetz mit den gleichen Impedanzen $Z_1$ bis $Z_3$ und den gleichen Spannungen $V_1$ bis $V_3$ (mit 120 Grad Phasendifferenz) ausgegangen. Demzufolge können die Impedanzen basierend auf einem einphasigen System ermittelt werden, das in Fig. 2 gezeigt ist. In dem einphasigen System gemäß Fig. 2 stellt $V_G$ den Wert der identischen Spannungen $V_1$ bis $V_3$ aus Fig. 1 dar und $Z_G$ entspricht dem Wert der identischen Impedanzen $Z_1$ bis $Z_3$ der Fig. 1. Die Spannung $V_{PCC}$ bzw. der Strom $I_{PCC}$ am Anschlusspunkt PCC entspricht der Spannung bzw. dem Strom einer Phase. Die Spannung $V_{PCC}$ wird von der angeschlossenen Energieerzeugungsanlage gemessen. Ebenso wird der Strom $I_{PCC}$ sowie die Blindleistung $Q_{PCC}$ und die Wirkleistung $P_{PCC}$ durch die Energieerzeugungsanlage ermittelt. In Analogie zur Fig. 1 wird die Impedanz $Z_T$ des Transformators wieder in die Impedanz $Z_G$ des Energienetzes hineingerechnet.

Ziel der nachfolgend beschriebenen Ausführungsform des erfindungsgemäßen Verfahrens ist es nunmehr, basierend auf den Messwerten $V_{PCC}$, $Q_{PCC}$ und $P_{PCC}$ die Impedanz des Energienetzes korrekt zu bestimmen. Theoretisch kann die Impedanz $Z_G$ in an sich bekannter Weise über folgende Formel ermittelt werden:

$$Z_G = \frac{U_2 - U_1}{I_2 - I_1}$$

Dabei sind $U_2$ und $I_2$ die komplexwertigen Spannungen bzw. Ströme zu einem Zeitpunkt am Anschlusspunkt sowie $U_1$ und $I_1$ die entsprechenden komplexwertigen Spannungen bzw. Ströme zu einem anderen Zeitpunkt am Anschlusspunkt. Die obigen Spannungen bzw. Ströme beinhalten somit einen Phasenwert. Dabei erweist sich die Bestimmung dieser Phasenwerte aufgrund von Frequenzschwankungen des Energienetzes für problematisch. Um dennoch einen korrekten Impedanzwert $Z_G$ zu ermitteln, wird im Folgenden eine Rechenvorschrift verwendet, welche den Impedanzwert unter der Annahme einer konstanten Phase der Spannung am Anschlusspunkt bestimmt. Man macht sich dabei die Erkenntnis zu Nutze, dass im Betrieb des Stromnetzes immer wieder Betriebspunkte auftreten, bei denen eine Schätzung der Impedanz mit dieser Rechenvorschrift zu geringen Schätzfehlern führt. Durch Analyse des Schätzfehlers kann dabei festgelegt werden, wann eine entsprechende Schätzung der Impedanz als gültig eingestuft wird.

Im Besonderen haben die Erfinder dabei erkannt, dass die Verwendung einer Rechenvorschrift, welche eine konstante Phase der gemessenen Spannung annimmt, immer dann zu geringen Schätzfehlern führt, wenn eine Veränderung der gemessenen Spannung und Blindleistung am Anschlusspunkt bei gleichzeitig geringer Variation der Wirkleistung auftritt und das Energienetz reaktiv ist, d.h. wenn der Realteil der Impedanz des Energienetzes klein ist. Die letztere Annahme ist in der Regel bei Anschluss einer Energieerzeugungsanlage an ein Hochvolt-Energienetz erfüllt.

Als Rechenvorschrift zur Schätzung der Impedanz wird folgendes, bereits oben erwähntes Gleichungssystem verwendet:

$$Z_{GE} = \frac{U_2 - U_1}{\left(\dfrac{P_2}{U_2} - \dfrac{P_1}{U_1}\right) - \left(\dfrac{jQ_2}{U_2} - \dfrac{jQ_1}{U_1}\right)}$$

wobei $Z_{GE}$ der geschätzte Impedanzwert ist;
wobei $U_2$ die gemessene Spannung, $Q_2$ die gemessene Blindleistung und $P_2$ die gemessene Wirkleistung am Anschlusspunkt zu einem Zeitpunkt aus einer Anzahl von Zeitpunkten umfassend den aktuellen und einen oder mehrere vorhergehende Zeitpunkte ist;
wobei $U_1$ bzw. $Q_1$ bzw. $P_1$ die gemessene Spannung bzw. die gemessene Blindleistung bzw. die gemessene Wirkleistung am Anschlusspunkt zu dem Zeitpunkt vor dem Zeitpunkt ist, an dem die Spannung

$U_2$, die Blindleistung $Q_2$ und die Wirkleistung $P_2$ gemessen werden.

In einer einfachen Variante wird dabei lediglich der aktuelle Zeitpunkt und der unmittelbar vorhergehende Zeitpunkt betrachtet, so dass das Gleichungssystem nur eine Gleichung umfasst. In diesem Fall beziehen sich $U_2$, $Q_2$ und $P_2$ auf den aktuellen Zeitpunkt und $U_1$, $Q_1$ und $P_1$ auf den unmittelbar vorhergehenden Zeitpunkt.

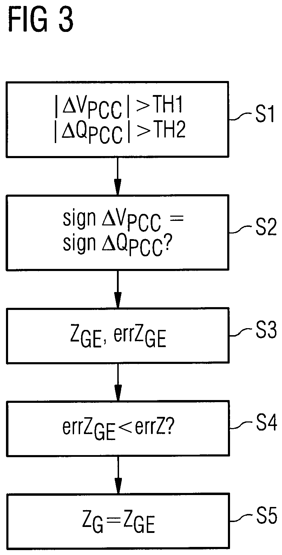

Im Folgenden werden die wesentlichen Schritte des erfindungsgemäßen Verfahrens anhand von Fig. 3 erläutert. Das Verfahren wird dabei schrittweise immer zu entsprechenden aktuellen Zeitpunkten t durchgeführt, und Fig. 3 zeigt die Verfahrensschritte zu einem entsprechenden Zeitpunkt t. Zu diesem Zeitpunkt wird in einem Schritt S1 überprüft, ob die betragsmäßige Veränderung $|\Delta V_{PCC}|$ der Spannung $V_{PCC}$ am Anschlusspunkt zwischen aktuellem und vorhergehendem Zeitpunkt größer als ein Schwellwert TH1 ist und ob die betragsmäßige Veränderung $|\Delta Q_{PCC}|$ der Blindleistung $Q_{PCC}$ am Anschlusspunkt zwischen aktuellem und vorhergehendem Zeitpunkt größer als ein Schwellwert TH2 ist. Hierbei wird die Erkenntnis genutzt, dass eine notwendige Voraussetzung für geringe Schätzfehler bei Verwendung der oben genannten Rechenvorschrift darin besteht, dass eine Variation der Spannung und Blindleistung am Anschlusspunkt auftritt. In einer bevorzugten Variante werden die Schwellwerte TH1 und TH2 in Abhängigkeit von einer vorab ermittelten Genauigkeit für die Messung der Spannung bzw. der Blindleistung bestimmt. Insbesondere stellen die entsprechenden Schwellen das Produkt aus einem positiven Faktor größer Eins (z.B. 5) und einer entsprechenden Messgenauigkeit in Prozent dar.

Nur wenn die Bedingungen gemäß Schritt S1 erfüllt sind, wird die Schätzung der Impedanz zum aktuellen Zeitpunkt fortgesetzt, ansonsten wird die Schätzung beendet. Sind die Bedingungen gemäß Schritt S1 erfüllt, wird im Schritt S2 überprüft, ob die entsprechenden Veränderungen der Spannung bzw. Blindleistung am Anschlusspunkt durch die Energieerzeugungsanlage oder das Energienetz hervorgerufen sind. Nur im Falle, wenn die Energieerzeugungsanlage die Variation der Spannung bzw. der Blindleistung hervorruft, ist eine Schätzung der Impedanz möglich. In der hier beschriebenen Ausführungsform wird in Schritt S2 überprüft, ob das Vorzeichen der Veränderung $\Delta V_{PCC}$ der Spannung $V_{PCC}$ dem Vorzeichen der Veränderung $\Delta Q_{PCC}$ der Blindleistung $Q_{PCC}$ entspricht. Nur wenn die Vorzeichen übereinstimmen, wurde die Veränderung der Spannung bzw. der Blindleistung durch die Energieerzeugungsanlage ausgelöst. Ist dies der Fall, wird das Verfahren mit Schritt S3 fortgesetzt. Ansonsten wird die Schätzung der Impedanz zum aktuellen Zeitpunkt beendet.

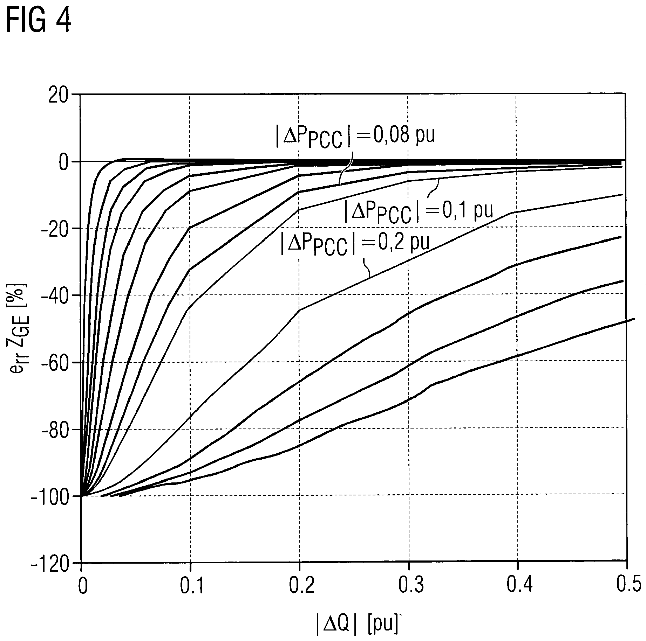

Bei Fortsetzung des Verfahrens wird im Schritt S3 nunmehr der Impedanzwert $Z_{GE}$ basierend auf der obigen Rechenvorschrift geschätzt. Ferner wird ein Schätzfehler $errZ_{GE}$ für diese Schätzung ermittelt. Die Bestimmung des Schätzfehlers beruht dabei auf einer Relation, welche vorab für die Simulation eines Energienetzes bzw. ggf. im Realbetrieb des Energienetzes bestimmt wurde. Fig. 4 zeigt beispielhaft ein Diagramm, welches diese Relation beschreibt. In diesem Diagramm sind entsprechende Leistungswerte ohne Beschränkung der Allgemeinheit in pu (per unit) und der Schätzfehler in Prozent angegeben. Zur Bestimmung des Diagramms wurde im Rahmen einer Simulation des Energienetzes als Wert für die tatsächliche Impedanz $Z_G$ = 0,0707 + 0,4950j (in pu) zugrunde gelegt. In dem Diagramm wird der Schätzfehler err$Z_{GE}$ in Abhängigkeit von der betragsmäßigen Variation $|\Delta Q_{PCC}|$ der Blindleistung angegeben, wobei die unterschiedlichen Linien in dem Diagramm für verschiedene Werte der betragsmäßigen Variation $|\Delta P_{PCC}|$ der Wirkleistung $\Delta P_{PCC}$ gültig sind. In Fig. 4 ist lediglich beispielhaft für drei Linien die betragsmäßige Variation der Wirkleistung angegeben, für welche die entsprechende Linie gültig ist. Die betragsmäßige Variation der Wirkleistung nimmt dabei für die Linien von links nach rechts zu.

Das Diagramm der Fig. 4 wurde für einen vorbestimmten Wert der Wirkleistung zum aktuellen Zeitpunkt bestimmt. Zur Bestimmung des Schätzfehlers existieren dabei eine Vielzahl der Diagramme gemäß Fig. 4, wobei jedes Diagramm für einen unterschiedlichen Wert der Wirkleistung durch Simulationen ermittelt wurde. Zur Bestimmung des Schätzfehlers in Schritt S3 wird nunmehr das entsprechende Diagramm ausgesucht, das dem aktuellen Wert der Wirkleistung am Anschlusspunkt entspricht. Anschließend wird die Linie herausgesucht, welche der Variation der Wirkleistung am Anschlusspunkt entspricht. Basierend auf dieser Linie wird dann für die betragsmäßige Variation der Blindleistung der Schätzfehler abgelesen. Wie man aus dem Diagramm der Fig. 4 kennt, sind die Schätzfehler immer dann klein, wenn die Variation der Blindleistung groß ist und die Variation der Wirkleistung gering ist, d.h. immer dann ist die obige Rechenvorschrift zur Schätzung von $Z_{GE}$ geeignet.

In einem Schritt S4 wird nach Bestimmung des Schätzfehlers ermittelt, ob dieser Schätzfehler kleiner als der Schätzfehler errZ ist. Der Schätzfehler errZ ist dabei der zuletzt zu einem früheren Zeitpunkt bestimmte Schätzfehler. Nur im Falle, wenn der aktuelle Schätzfehler err$Z_{GE}$ kleiner als der zuletzt bestimmte Schätzfehler errZ ist, wird im Schritt S5 der geschätzte Impedanzwert $Z_{GE}$ als ein gültiger ermittelter Impedanzwert $Z_G$ betrachtet. Ist die Bedingung aus Schritt S4 nicht erfüllt, wird die Schätzung der Impedanz zum aktuellen Zeitpunkt abgebrochen. Der in Schritt S5 bestimmte Impedanzwert kann dann in der Energieerzeugungsanlage bzw. entsprechenden Steuereinheit(en) in der Energieerzeugungsanlage geeignet verarbeitet werden, um den Betrieb der Anlage an die Gegebenheiten des Energienetzes anzupassen.

In einer besonders bevorzugten Ausführungsform des oben beschriebenen Verfahrens wird ferner unter bestimmten Bedingungen eine aktive Veränderung von Parametern der Energieerzeugungsanlage durchgeführt, wobei die Veränderung der Parameter die Spannung bzw. Blindleistung am Anschlusspunkt beeinflussen. In einer Variante wird eine solche Veränderung dann durchgeführt, wenn die Zeitspanne seit dem letzten Zeitpunkt, an dem Schritt S5 durchgeführt wurde, eine vorbestimmte Schwelle überschreitet. Hierdurch wird erreicht, dass neue Betriebsbedingungen geschaffen werden, wenn die aktuellen Betriebsbedingungen für eine lange Zeit nicht mehr zu einer geeigneten Schätzung einer Impedanz geführt haben. Vorzugsweise ist die aktive Anregung der Energieerzeugungsanlage derart ausgestaltet, dass dabei die Wirkleistung am Anschlusspunkt konstant bleibt. In diesem Fall ist damit zu rechnen, dass wieder Bedingungen vorliegen, gemäß denen eine Schätzung der Impedanz möglich ist.

In einer weiteren Ausgestaltung wird bei einem signifikanten Ereignis in dem Energienetz ebenfalls eine aktive Anregung der Energieerzeugungsanlage durchgeführt. Ein signifikantes Ereignis wird dann festgestellt, wenn die Bedingung gemäß Schritt S2 nicht erfüllt ist, jedoch die betragsmäßige Veränderung der Spannung und/oder die betragsmäßige Veränderung der Blindleistung sehr groß ist. Hierzu werden entsprechende Schwellwerte für die betragsmäßigen Veränderungen festgelegt, welche deutlich größer als die Schwellwerte TH1 und TH2 sind. Diese Variante der Erfindung berücksichtigt, dass ein signifikantes Ereignis im Energienetz zu einer Veränderung seiner Impedanz führt, so dass eine Aktualisierung des Impedanzwerts erforderlich ist.

Die im Vorangegangenen beschriebenen Ausführungsformen des erfindungsgemäßen Verfahrens weisen eine Reihe von Vorteilen auf. Insbesondere können während des Betriebs einer Energieerzeugungsanlage online gute Schätzungen der Impedanz am Anschlusspunkt der Anlage mit geringen aktiven Störungen des Energienetzes ermittelt werden. Die Erfindung beruht dabei auf der Erkenntnis, dass für bestimmte Betriebspunkte der Energieerzeugungsanlage bzw. des Energienetzes eine genaue Schätzung einer Impedanz möglich ist, ohne dabei die Phasenvariation der Spannung am Anschlusspunkt zu berücksichtigen, welche aufgrund von Frequenzinstabilitäten nicht genau bestimmt werden kann. Das erfindungsgemäße Verfahren kann für beliebige Arten von Energieerzeugungsanlagen verwendet werden, wobei in einer bevorzugten Ausführungsform die Energieerzeugungsanlage eine Windfarm aus mehreren Windturbinen ist.

Das Energienetz, an das die Energieerzeugungsanlage angeschlossen ist, ist insbesondere ein Hochvolt-Energienetz, für welche die Impedanz im Wesentlichen reaktiv ist und somit nur einen kleinen oder keinen Realteil aufweist.

**Patentansprüche**

**1.** Verfahren zur rechnergestützten Ermittlung der Impedanz ($Z_G$) eines elektrischen Energienetzes (EN), wobei an einem Anschlusspunkt (PCC), an dem eine elektrische Energieerzeugungsanlage an das Energienetz (EN) angeschlossen ist, zu jeweiligen aufeinander folgenden Zeitpunkten die elektrische Spannung ($V_{PCC}$), die Wirkleistung ($P_{PPC}$) und die Blindleistung ($Q_{PCC}$) gemessen werden, wobei ein Impedanzwert ($Z_G$) des Energienetzes (EN) ermittelt wird, indem:

a) zu einem jeweiligen aktuellen Zeitpunkt ermittelt wird, ob die betragsmäßige Veränderung ($|\Delta V_{PCC}|$) der gemessenen Spannung ($V_{PCC}$) zwischen dem vorhergehenden und dem aktuellen Zeitpunkt und die betragsmäßige Veränderung ($|\Delta Q_{PCC}|$) der gemessenen Blindleistung ($Q_{PCC}$) zwischen dem vorhergehenden und dem aktuellen Zeitpunkt ein erstes Kriterium erfüllen, wobei das erste Kriterium dann erfüllt ist, wenn die betragsmäßige Veränderung ($|\Delta V_{PCC}|$) der gemessenen Spannung ($V_{PCC}$) größer als ein erster Schwellwert (TH1) ist und die betragsmäßige Veränderung ($|\Delta Q_{PCC}|$) der gemessenen Blindleistung ($Q_{PCC}$) größer als ein zweiter Schwellwert ist;
b) nur im Falle, dass die betragsmäßigen Veränderungen ($|\Delta V_{PCC}|$, $|\Delta Q_{PCC}|$) der gemessenen Spannung ($V_{PCC}$) und der gemessenen Blindleistung ($Q_{PCC}$) das erste Kriterium erfüllen, ermittelt wird, ob die Veränderungen ($\Delta V_{PCC}$, $\Delta Q_{PCC}$) der gemessenen Spannung ($V_{PCC}$) und der gemessenen Blindleistung ($Q_{PCC}$) ein zweites Kriterium erfüllen, wobei das zweite Kriterium dann erfüllt ist, wenn die Veränderungen ($\Delta V_{PCC}$, $\Delta Q_{PCC}$) der gemessenen Spannung ($V_{PCC}$) und der gemessenen Blindleistung ($Q_{PCC}$) durch die Energieerzeugungsanlage verursacht sind, wobei das zweite Kriterium derart überprüft wird, dass das Vorzeichen der Veränderung ($\Delta V_{PCC}$) der gemessenen Spannung ($V_{PCC}$) mit dem Vorzeichen der Veränderung ($\Delta Q_{PCC}$) der gemessenen Blindleistung ($Q_{PCC}$) verglichen wird, wobei das zweite Kriterium dann erfüllt ist, wenn die beiden Vorzeichen übereinstimmen;
c) nur im Falle, dass die Veränderungen ($|\Delta V_{PCC}|$, $|\Delta Q_{PCC}|$) der gemessenen Spannung ($V_{PCC}$) und der gemessenen Blindleistung ($Q_{PCC}$) das zweite Kriterium erfüllen, ein Impedanzwert ($Z_{GE}$) basierend auf einer Rechenvorschrift geschätzt wird, welche von der Phase der gemessenen Spannung ($V_{PCC}$) unabhängig ist und auf der Annahme einer konstanten Phase der gemessenen Spannung ($V_{PCC}$) beruht, und ein Schätzfehler ($errZ_{GE}$) für den geschätzten Impedanzwert ($Z_{GE}$) bestimmt wird, wobei ferner die Veränderung ($\Delta P_{PCC}$) der Wirkleistung ($\Delta P_{PCC}$) zwischen dem vorhergehenden und dem aktuellen Zeitpunkt ermittelt wird, wobei der Schätzfehler ($errZ_{GE}$) basierend auf einer vorbestimmten Relation bestimmt wird, welche den Schätzfehler ($errZ_{GE}$) in Abhängigkeit von der gemessenen Wirkleistung ($P_{PCC}$), der betragsmäßigen Veränderung ($|\Delta P_{PCC}|$) der gemessenen Wirkleistung ($P_{PCC}$) und der betragsmäßigen Veränderung ($|\Delta Q_{PCC}|$) der gemessenen Blindleistung ($Q_{PCC}$) angibt;
d) nur im Falle, dass der Schätzfehler ($errZ_{GE}$) kleiner als eine vorbestimmte Fehlerschwelle ($errZ_G$) ist, der geschätzte Impedanzwert ($Z_{GE}$) den ermittelten Impedanzwert ($Z_G$) darstellt.

2. Verfahren nach Anspruch 1, bei dem die vorbestimmte Fehlerschwelle ($errZ_G$) der Schätzfehler ist, der in dem zuletzt vor dem aktuellen Zeitpunkt durchgeführten Schritt d) ermittelt wurde.

3. Verfahren nach einem der vorhergehenden Ansprüche, bei dem der erste Schwellwert (TH1) ein Produkt aus einem positiven Faktor größer Eins und einer prozentualen Messgenauigkeit der gemessenen Spannung ($V_{PCC}$) ist und/oder der zweite Schwellwert (TH2) ein Produkt aus einem positiven Faktor größer Eins und einer prozentualen Messgenauigkeit der gemessenen Blindleistung ($Q_{PCC}$) ist.

4. Verfahren nach einem der vorhergehenden Ansprüche, bei dem ferner die Veränderung ($\Delta P_{PCC}$) der Wirkleistung ($\Delta P_{PCC}$) zwischen dem vorhergehenden und dem aktuellen Zeitpunkt ermittelt wird, wobei die Ermittlung des Impedanzwerts ($Z_G$) zum aktuellen Zeitpunkt abgebrochen wird, wenn die betragsmäßige Veränderung ($|\Delta P_{PCC}|$) der Wirkleistung ($P_{PCC}$) größer als ein dritter Schwellwert ist.

5. Verfahren nach einem der vorhergehenden Ansprüche, bei dem der Impedanzwert in Schritt c) über die gemessenen Spannungen ($V_{PCC}$), die gemessenen Wirkleistungen ($P_{PCC}$) und die gemessenen Blindleistungen ($Q_{PCC}$) zu einer Anzahl von Zeitpunkten umfassend den aktuellen und einen oder mehrere vorhergehende Zeitpunkte basierend auf einer oder mehreren der folgenden Gleichungen geschätzt wird:

$$Z_{GE} = \frac{U_2 - U_1}{\left(\dfrac{P_2}{U_2} - \dfrac{P_1}{U_1}\right) - \left(\dfrac{jQ_2}{U_2} - \dfrac{jQ_1}{U_1}\right)}$$

wobei $Z_{GE}$ der geschätzte Impedanzwert ist;
wobei $U_2$ die gemessene Spannung, $Q_2$ die ge-

messene Blindleistung und $P_2$ die gemessene Wirkleistung am Anschlusspunkt zu einem Zeitpunkt aus der Anzahl von Zeitpunkten ist; wobei $U_1$ bzw. $Q_1$ bzw. $P_1$ die gemessene Spannung bzw. die gemessene Blindleistung bzw. die gemessene Wirkleistung am Anschlusspunkt zu dem Zeitpunkt vor dem Zeitpunkt ist, an dem die Spannung $U_2$, die Blindleistung $Q_2$ und die Wirkleistung $P_2$ gemessen werden.

6. Verfahren nach einem der vorhergehenden Ansprüche, bei dem im Falle, dass die Zeitspanne seit dem letzten Zeitpunkt, an dem Schritt d) durchgeführt wurde, eine vorbestimmte Schwelle überschreitet, ein oder mehrere Parameter der Energieerzeugungsanlage derart variiert werden, dass die Spannung ($V_{PCC}$) und/oder die Blindleistung ($Q_{PCC}$) am Anschlusspunkt (PCC) verändert werden, wobei die Variation der Parameter die Durchführung der Schritte a) bis d) auslöst, wobei die Variation der Parameter vorzugsweise derart ausgestaltet ist, dass die Wirkleistung ($P_{PCC}$) am Anschlusspunkt (PCC) konstant bleibt.

7. Verfahren nach einem der vorhergehenden Ansprüche, bei dem im Falle, dass die betragsmäßige Veränderung ($\Delta V_{PCC}$) der gemessenen Spannung ($V_{PCC}$) größer als ein vierter Schwellwert ist, der größer als der erste Schwellwert ist, und/oder die betragsmäßige Veränderung ($\Delta Q_{PCC}$) der gemessenen Blindleistung ($Q_{PCC}$) größer als ein fünfter Schwellwert ist, der größer als der zweite Schwellwert ist, und die betragsmäßigen Veränderungen ($|\Delta V_{PCC}|$, $|\Delta Q_{PCC}|$) der gemessenen Spannung ($V_{PCC}$) und der gemessenen Blindleistung ($Q_{PCC}$) das zweite Kriterium nicht erfüllen, ein oder mehrere Parameter der Energieerzeugungsanlage derart variiert werden, dass die Spannung ($V_{PCC}$) und/oder die Blindleistung ($Q_{PCC}$) am Anschlusspunkt (PCC) verändert werden, wobei die Veränderung der Parameter die Durchführung der Schritte a) bis d) auslöst, wobei die Variation der Parameter vorzugsweise derart ausgestaltet ist, dass die Wirkleistung ($P_{PCC}$) am Anschlusspunkt (PCC) konstant bleibt.

8. Verfahren nach einem der vorhergehenden Ansprüche, bei dem die Energieerzeugungsanlage eine Windturbine oder ein Windpark aus mehreren Windturbinen ist.

9. Elektrische Energieerzeugungsanlage, wobei die Energieerzeugungsanlage derart ausgestaltet ist, dass sie bei Anschluss an einem Anschlusspunkt (PCC) eines Energienetzes ein Verfahren nach einem der Ansprüche 1 bis 8 durchführt.

10. Computerprogrammprodukt mit einem auf einem maschinenlesbaren Träger gespeicherten Programmcode welcher bewirkt, dass die Vorrichtung von Anspruch 9 das Verfahren nach einem der Ansprüche 1 bis 8 durchführt, wenn der Programmcode auf einem Computer ausgeführt wird.

**Claims**

1. Method for computer-aided ascertainment of the impedance ($Z_G$) of an electrical power supply system (EN), wherein, at a connection point (PCC) at which an electrical power generating installation is connected to the power supply system (EN), the electrical voltage ($V_{PCC}$), the active power ($P_{PCC}$) and the reactive power ($Q_{PCC}$) are measured at respective successive instants, with an impedance value ($Z_G$) for the power supply system (EN) being ascertained by:

a) ascertaining, at a respective present instant, whether the absolute-value change ($|\Delta V_{PCC}|$) in the measured voltage ($V_{PCC}$) between the preceding and present instants and the absolute-value change ($|\Delta Q_{PCC}|$) in the measured reactive power ($Q_{PCC}$) between the preceding and present instants satisfy a first criterion, wherein the first criterion is satisfied when the absolute-value change ($|\Delta V_{PCC}|$) in the measured voltage ($V_{PCC}$) is greater than a first threshold value (TH1) and the absolute-value change ($|\Delta Q_{PCC}|$) in the measured reactive power ($Q_{PCC}$) is greater than a second threshold value;
b) only if the absolute-value changes ($|\Delta V_{PCC}|$, $|\Delta Q_{PCC}|$) in the measured voltage ($V_{PCC}$) and the measured reactive power ($Q_{PCC}$) satisfy the first criterion, ascertaining whether the changes ($\Delta V_{PCC}$, $\Delta Q_{PCC}$) in the measured voltage ($V_{PCC}$) and the measured reactive power ($Q_{PCC}$) satisfy a second criterion, wherein the second criterion is satisfied when the changes ($\Delta V_{PCC}$, $\Delta Q_{PCC}$) in the measured voltage ($V_{PCC}$) and the measured reactive power ($Q_{PCC}$) are caused by the power generating installation, wherein the second criterion is checked such that the arithmetic sign of the change ($\Delta V_{PCC}$) in the measured voltage ($V_{PCC}$) is compared with the arithmetic sign of the change ($\Delta Q_{PCC}$) in the measured reactive power ($Q_{PCC}$), wherein the second criterion is satisfied when the two arithmetic signs match;
c) only if the changes ($|\Delta V_{PCC}|$, $|\Delta Q_{PCC}|$) in the measured voltage ($V_{PCC}$) and the measured reactive power ($Q_{PCC}$) satisfy the second criterion, estimating an impedance value ($Z_{GE}$) on the basis of a computation rule, which is independent of the phase of the measured voltage ($V_{PCC}$) and is based on the assumption of a constant phase of the measured voltage ($V_{PCC}$), and determining an estimation error ($errZ_{GE}$) for the estimated impedance value ($Z_{GE}$), wherein additionally the change ($\Delta P_{PCC}$) in the active power ($\Delta P_{PCC}$) between the preceding and present instants is ascertained, wherein the estimation error ($errZ_{GE}$) is determined on the basis of a predetermined relation that indicates the estimation error ($errZ_{GE}$) on the basis of the measured active power ($P_{PCC}$), the absolute-value change ($|\Delta P_{PCC}|$) in the measured active power ($P_{PCC}$) and the absolute-value change ($|\Delta Q_{PCC}|$) in the measured reactive power ($Q_{PCC}$) ;

d) the estimated impedance value ($Z_{GE}$) representing the ascertained impedance value ($Z_G$) only if the estimation error ($errZ_{GE}$) is below a predetermined error threshold ($errZ_G$) .

2. Method according to Claim 1, in which the predetermined error threshold ($errZ_G$) is the estimation error that has been ascertained in step d) performed most recently before the present instant.

3. Method according to one of the preceding claims, in which the first threshold value (TH1) is a product of a positive factor greater than one and a percentage measurement accuracy for the measured voltage ($V_{PCC}$) and/or the second threshold value (TH2) is a product of a positive factor greater than one and a percentage measurement accuracy for the measured reactive power ($Q_{PCC}$).

4. Method according to one of the preceding claims, in which additionally the change ($\Delta P_{PCC}$) in the active power ($\Delta P_{PCC}$) between the preceding and present instants is ascertained, wherein the ascertainment of the impedance value ($Z_G$) at the present instant is terminated if the absolute-value change ($|\Delta P_{PCC}|$) in the active power ($P_{PCC}$) is greater than a third threshold value.

5. Method according to one of the preceding claims, in which the impedance value is estimated in step c) using the measured voltages ($V_{PCC}$), the measured active powers ($P_{PCC}$) and the measured reactive powers ($Q_{PCC}$) to produce a number of instants comprising the present instant and one or more preceding instants on the basis of one or more of the following equations:

$$Z_{GE} = \frac{U_2 - U_1}{\left(\dfrac{P_2}{U_2} - \dfrac{P_1}{U_1}\right) - \left(\dfrac{jQ_2}{U_2} - \dfrac{jQ_1}{U_1}\right)}$$

where $Z_{GE}$ is the estimated impedance value; where $U_2$ is the measured voltage, $Q_2$ is the

measured reactive power and $P_2$ is the measured active power at the connection point at an instant from the number of instants;

where $U_1$ and $Q_1$ and $P_1$ are the measured voltage and the measured reactive power and the measured active power, respectively, at the connection point at the instant before the instant at which the voltage $U_2$, the reactive power $Q_2$ and the active power $P_2$ are measured.

6. Method according to one of the preceding claims, in which if the period of time since the last instant at which step d) was performed exceeds a predetermined threshold, one or more parameters of the power generating installation are varied such that the voltage ($V_{PCC}$) and/or the reactive power ($Q_{PCC}$) at the connection point (PCC) are changed, wherein the variation in the parameters initiates the performance of steps a) to d), the variation in the parameters preferably being embodied such that the active power ($P_{PCC}$) at the connection point (PCC) remains constant.

7. Method according to one of the preceding claims, in which if the absolute-value change ($\Delta V_{PCC}$) in the measured voltage ($V_{PCC}$) is greater than a fourth threshold value, which is greater than the first threshold value, and/or the absolute-value change ($\Delta Q_{PCC}$) in the measured reactive power ($Q_{PCC}$) is greater than a fifth threshold value, which is greater than the second threshold value, and the absolute-value changes ($|\Delta V_{PCC}|, |\Delta Q_{PCC}|$) in the measured voltage ($V_{PCC}$) and the measured reactive power ($Q_{PCC}$) do not satisfy the second criterion, one or more parameters of the power generating installation are varied such that the voltage ($V_{PCC}$) and/or the reactive power ($Q_{PCC}$) at the connection point (PCC) are changed, wherein the change in the parameters initiates the performance of steps a) to d), the variation in the parameters preferably being embodied such that the active power ($P_{PCC}$) at the connection point (PCC) remains constant.

8. Method according to one of the preceding claims, in which the power generating installation is a wind turbine or a wind farm comprising a plurality of wind turbines.

9. Electrical power generating installation, wherein the power generating installation is embodied such that, when connected to a connection point (PCC) of a power supply system, it performs a method according to one of Claims 1 to 8.

10. Computer program product having a program code, stored on a machine-readable storage medium, which causes the device of Claim 9 to perform the method according to one of Claims 1 to 8 when the program code is executed on a computer.

**Revendications**

1. Procédé assisté par ordinateur servant à déterminer l'impédance ($Z_G$) d'un réseau d'énergie électrique (EN), dans lequel sur un point de raccordement (PCC) sur lequel une installation de production d'énergie électrique est raccordée au réseau d'énergie (EN), à des moments consécutifs respectifs, la tension électrique ($V_{PCC}$), la puissance active ($P_{PCC}$) et la puissance réactive ($Q_{PCC}$) sont mesurées, dans lequel une valeur d'impédance ($Z_G$) du réseau d'énergie (EN) est déterminée, en ce que :

   a) à un moment actuel respectif, il est déterminé si la modification relative à la grandeur ($|\Delta V_{PCC}|$) de la tension ($V_{PCC}$) mesurée entre le moment précédent et actuel et la modification relative à la grandeur ($|\Delta Q_{PCC}|$) de la puissance réactive ($Q_{PCC}$) mesurée entre le moment précédent et actuel remplissent un premier critère, dans lequel le premier critère est rempli lorsque la modification relative à la grandeur ($|\Delta V_{PCC}|$) de la tension ($V_{PCC}$) mesurée est supérieure à une première valeur seuil (TH1) et la modification relative à la grandeur ($|\Delta Q_{PCC}|$) de la puissance réactive ($Q_{PCC}$) mesurée est supérieure à une deuxième valeur seuil ;
   b) uniquement dans le cas où les modifications relatives à la grandeur ($|\Delta V_{PCC}|$, ($|\Delta Q_{PCC}|$) de la tension ($V_{PCC}$) mesurée et de la puissance réactive ($Q_{PCC}$) mesurée remplissent le premier critère, il est déterminé si les modifications ($\Delta V_{PCC}$, $\Delta Q_{PCC}$) de la tension ($V_{PCC}$) mesurée et de la puissance réactive ($Q_{PCC}$) mesurée remplissent un deuxième critère, dans lequel le deuxième critère est rempli lorsque les modifications ($\Delta V_{PCC}$, $\Delta Q_{PCC}$) de la tension ($V_{PCC}$) mesurée et de la puissance réactive ($Q_{PCC}$) mesurée sont provoquées par l'installation de production d'énergie, dans lequel le deuxième critère est ainsi vérifié que le signe de la modification ($\Delta V_{PCC}$) de la tension ($V_{PCC}$) mesurée est comparé au signe de la modification ($\Delta Q_{PCC}$) de la puissance réactive ($Q_{PCC}$) mesurée, dans lequel le deuxième critère est rempli lorsque les deux signes concordent ;
   c) uniquement dans le cas où les modifications ($|\Delta V_{PCC}|$, ($|\Delta Q_{PCC}|$) de la tension ($V_{PCC}$) mesurée et de la puissance réactive ($Q_{PCC}$) mesurée remplissent le deuxième critère, une valeur d'impédance ($Z_{GE}$) est estimée en se basant sur une instruction de calcul qui est indépendante de la phase de la tension ($V_{PCC}$) mesurée et repose sur la supposition d'une phase constante de la tension ($V_{PCC}$) mesurée, et une erreur

d'estimation (err$Z_{GE}$) est déterminée pour la valeur d'impédance ($Z_{GE}$) estimée, dans lequel en outre, la modification ($\Delta P_{PCC}$) de la puissance active ($\Delta P_{PCC}$) entre le moment précédent et actuel est déterminée, dans lequel l'erreur d'estimation (err$Z_{GE}$) est déterminée en se basant sur une relation prédéterminée, laquelle indique l'erreur d'estimation (err$Z_{GE}$) en fonction de la puissance active ($P_{PCC}$) mesurée, de la modification relative à la grandeur ($|\Delta P_{PCC}|$) de la puissance active ($P_{PCC}$) mesurée et de la modification relative à la grandeur ($|\Delta Q_{PCC}|$) de la puissance réactive ($Q_{PCC}$) mesurée ;
   d) uniquement dans le cas où l'erreur d'estimation (err$Z_{GE}$) est inférieure à un seuil d'erreur (err$Z_G$) prédéterminé, la valeur d'impédance estimée ($Z_{GE}$) représente la valeur d'impédance ($Z_G$) déterminée.

2. Procédé selon la revendication 1, dans lequel le seuil d'erreur (err$Z_G$) prédéterminé est l'erreur d'estimation qui a été déterminée dans l'étape d) exécutée en dernier avant le moment actuel.

3. Procédé selon l'une des revendications précédentes, dans lequel la première valeur seuil (TH1) est un produit d'un facteur positif supérieur à un et d'une précision de mesure en pourcentage de la tension ($V_{PCC}$) mesurée et/ou la deuxième valeur seuil (TH2) est un produit d'un facteur positif supérieur à un et d'une précision de mesure en pourcentage de la puissance réactive ($Q_{PCC}$) mesurée.

4. Procédé selon l'une des revendications précédentes, dans lequel en outre la modification ($|\Delta P_{PCC}|$) de la puissance active ($\Delta P_{PCC}$) entre le moment précédent et actuel est déterminée, dans lequel la détermination de la valeur d'impédance ($Z_G$) au moment actuel est interrompue lorsque la modification relative à la grandeur ($|\Delta P_{PCC}|$) de la puissance active ($P_{PCC}$) est supérieure à une troisième valeur seuil.

5. Procédé selon l'une des revendications précédentes, dans lequel la valeur d'impédance à l'étape c) sur les tensions ($V_{PCC}$) mesurées, les puissances actives ($P_{PCC}$) mesurées et les puissances réactives ($Q_{PCC}$) mesurées à un nombre de moments comprenant le moment actuel et un ou plusieurs moments précédents est estimée en se basant sur une ou plusieurs des équations suivantes :

$$Z_{GE} = \frac{U_2 - U_1}{\left(\dfrac{P_2}{U_2} - \dfrac{P_1}{U_1}\right) - \left(\dfrac{jQ_2}{U_2} - \dfrac{jQ_1}{U_1}\right)}$$

dans lequel $Z_{GE}$ est la valeur d'impédance estimée ;

dans lequel $U_2$ est la tension mesurée, $Q_2$ la puissance réactive mesurée et $P_2$ la puissance active mesurée au point de raccordement à un moment issu du nombre de moments ;

dans lequel $U_1$, respectivement $Q_1$, respectivement $P_1$ sont la tension mesurée, respectivement la puissance réactive mesurée, respectivement la puissance active mesurée au point de raccordement au moment avant le moment où la tension $U_2$, la puissance réactive $Q_2$ et la puissance active $P_2$ sont mesurées.

6. Procédé selon l'une des revendications précédentes, dans lequel, dans le cas où le laps de temps depuis le dernier moment où l'étape d) a été exécutée, dépasse un seuil prédéterminé, un ou plusieurs paramètre(s) de l'installation de production d'énergie sont variés de façon à ce que la tension ($V_{PCC}$) et/ou la puissance réactive ($Q_{PCC}$) au point de raccordement (PCC) soient modifiées, dans lequel la variation des paramètres déclenche l'exécution des étapes a) à d), dans lequel la variation des paramètres est ainsi conçue de préférence que la puissance active ($P_{PCC}$) au point de raccordement (PCC) reste constante.

7. Procédé selon l'une des revendications précédentes, dans lequel, dans le cas où la modification relative à la grandeur ($|\Delta V_{PCC}|$) de la tension ($V_{PCC}$) mesurée est supérieure à une quatrième valeur seuil qui est supérieure à la première valeur seuil, et/ou la modification relative à la grandeur ($|\Delta Q_{PCC}|$) de la puissance réactive ($Q_{PCC}$) mesurée est supérieure à une cinquième valeur seuil qui est supérieure à la deuxième valeur seuil, et les modifications relatives à la grandeur ($|\Delta V_{PCC}|$, ($|\Delta Q_{PCC}|$) de la tension ($V_{PCC}$) mesurée et de la puissance réactive ($Q_{PCC}$) mesurée ne remplissent pas le deuxième critère, un ou plusieurs paramètre(s) de l'installation de production d'énergie sont variés de façon à ce que la tension ($V_{PCC}$) et/ou la puissance réactive ($Q_{PCC}$) au point de raccordement (PCC) soient modifiées, dans lequel la variation des paramètres déclenche l'exécution des étapes a) à d), dans lequel la variation des paramètres est ainsi conçue de préférence que la puissance active ($P_{PCC}$) au point de raccordement (PCC) reste constante.

8. Procédé selon l'une des revendications précédentes, dans lequel l'installation de production d'énergie est une éolienne ou un parc éolien de plusieurs éoliennes.

9. Installation de production d'énergie, dans laquelle l'installation de production d'énergie est ainsi conçue que lors du raccordement à un point de raccordement (PCC) d'un réseau d'énergie, elle exécute un procédé selon l'une des revendications 1 à 8.

10. Produit de programme informatique comprenant un code de programme enregistré sur un support lisible sur machine qui a pour effet que le dispositif selon la revendication 9 exécute le procédé selon l'une des revendications 1 à 8 lorsque le code de programme est exécuté sur un ordinateur.

## FIG 1

## FIG 2

## FIG 3

$$|\Delta V_{PCC}| > TH1$$
$$|\Delta Q_{PCC}| > TH2$$ — S1

$$\text{sign } \Delta V_{PCC} =$$
$$\text{sign } \Delta Q_{PCC}?$$ — S2

$$Z_{GE}, \text{ err}Z_{GE}$$ — S3

$$\text{err}Z_{GE} < \text{err}Z?$$ — S4

$$Z_G = Z_{GE}$$ — S5

## FIG 4

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 19522496 C1
- EP 2397689 A1

- WO 2012166933 A1

**In der Beschreibung aufgeführte Nicht-Patentliteratur**

- Inselnetzerkennung bei Eigenerzeugungsanlagen. **HANDSCHIN et al.** ELEKTROTECHNISCHE ZEITSCHRIFT - ETZ. VDE VERLAG GMBH, 01. Januar 2004, vol. 125, 48-50